# EUROPÄISCHE PATENTSCHRIFT

(11) **EP 1 825 534 B1**
(45) Veröffentlichungstag und Bekanntmachung des Hinweises auf die Patenterteilung: **13.08.2008**
(21) Anmeldenummer: 05821027.9
(22) Anmeldetag: 30.11.2005
(51) Int. Cl.: H01L 51/00

(54) **VERFAHREN ZUM STRUKTURIERTEN AUFBRINGEN VON MOLEKÜLEN AUF EINE LEITERBAHN SOWIE MOLEKULARE SPEICHERMATRIX**
METHOD FOR STRUCTURED APPLICATION OF MOLECULES ON A STRIP CONDUCTOR AND MOLECULAR MEMORY MATRIX
PROCEDE POUR L'APPLICATION STRUCTUREE DE MOLECULES SUR UN TRACE CONDUCTEUR ET MATRICE DE MEMOIRE MOLECULAIRE

(30) Priorität: 15.12.2004 DE 102004060738
(43) Veröffentlichungstag der Anmeldung: 29.08.2007
(73) Patentinhaber: Forschungszentrum Jülich GmbH, 52425 Jülich (DE)
(72) Erfinder: KRONHOLZ, Stephan, 01324 Dresden (DE); KARTHÄUSER, Silvia, 51107 Köln (DE)
(86) Internationale Anmeldenummer: PCT/DE2005/002157
(87) Internationale Veröffentlichungsnummer: WO 2006/063553

(56) Entgegenhaltungen:
- US-A- 6 159 620
- US-A1- 2004 166 673
- US-B1- 6 773 954
- FENDLER J H: "Chemical self-assembly for electronic applications" CHEMISTRY OF MATERIALS AMERICAN CHEM. SOC USA, Bd. 13, Nr. 10, 18. Juli 2001 (2001-07-18), Seiten 3196-3210, XP002371903 ISSN: 0897-4756

## Beschreibung

Die Erfindung betrifft ein Verfahren zum strukturierten Aufbringen von Molekülen auf eine Leiterbahn sowie eine molekulare Speichermatrix.

In der Molekularelektronik sind Verfahren wie beispielsweise die "Nanogap-Methode" (C. Li, H. He, N.J. Tao, Applied Physics Letters 77, 3995 (2000*))* sowie die "Break-Junction-Methode" (M.A. Reed, C. Zhou, C.J. Muller, T. P. Burgin, and J.M. Tour, Science 278, 252 (1997*))* bekannt, mit denen Einzelmoleküle kontaktiert werden können. Andere Methoden bestehen darin, Moleküle, als monomolekulare Schicht zu kontaktieren. Ein Verfahren zum Aufbringen von Molekülen als monomolekulare Schicht ist das Eintauchen des Substrates (gewünschter Träger der molekularen Schicht) in ein Bad bestehend aus Molekülen und Lösungsmittel. Weiterhin ist zur Herstellung von monomolekularen Molekülschichten auch die "Langmuir-Blodgett-Methode" (H. Wang, A. Reichert, J.O. Nagy, Langmuir 13, 6524 (1997) ) möglich.

Bei der Verwendung von monomolekularen Schichten besteht der Nachteil darin, dass nur komplette Schichten oder Schichtsysteme aufgebaut und kontaktiert werden können. Dies macht die Adressierung von Einzelmolekülen unmöglich. Die Realisierung einer molekularen Speichermatrix ist mit dieser Methode nur schwer möglich, weil die aufgebrachte molekulare Schicht nur unter erheblichem Aufwand strukturierbar ist. Dabei hängt die Strukturgröße immer vom jeweils aktuell besten Strukturierungsverfahren ab. Zur Zeit ist dies die Elektronenstrahllithographie mit der bis zu 2 nm strukturiert werden können. Jedoch handelt es sich hierbei um eine zeitaufwendige sequentielle Methode. Mit diesem Verfahren kann man nicht in den Bereich einzelner Moleküle vordringen.

Sollen monomolekulare Schichten strukturiert werden, besteht die Gefahr, dass die als Speicherelemente vorgesehenen Moleküle beschädigt werden. Weiterhin besteht der Nachteil, dass Moleküle, die mit Hilfe der "Langmuir-Blodgett-Methode" aufgebracht wurden, keine chemischen Bindungen zu den Elektroden bilden. Durch diese Tatsache ergibt sich ein hoher Molekül-Elektrode Kontaktwiderstand und eine geringe Stabilität der Molekülschicht. Mit Hilfe der "Nanogap-Methode" oder der "Break-Junction-Methode" ist es ebenfalls nicht möglich, eine schaltende Matrix bestehend aus einer großen Zahl von Molekülspeicherelementen aufzubauen.

Aus der US 6,159,620 ist ein Verfahren zum Aufbringen von Molekülen auf Leiterbahnen bekannt, bei dem organisch funktionalisierte Silber-Nanokristalle auf Aluminiumelektroden aufgebracht werden. Die Nanokristalle können als Monolage aufgebracht werden, sind jedoch nicht individuell adressierbar.

Mit Hilfe der zuvor genannten Methoden ist es prinzipiell nicht möglich, mehrere Molekülkontaktstellen in eine Speichermatrix mit nm-Dimension zu integrieren.

Darüber hinaus werden für einige Matrixanordnungen immer zwei Elektrodenpaare benötigt; ein Paar zum "Adressieren" und ein Paar zum "Auslesen" der Information innerhalb des Moleküls. Somit gibt es zum jetzigen Zeitpunkt lediglich verschiedene Methoden, um gezielt einzelne Moleküle anzusprechen, jedoch nur als Einzelmolekülkontakt nicht aber als Array.

Als Bottomelektrode für die Kontaktierung von Molekülen werden nach dem Stand der Technik bisher überwiegend dünne Goldfilme auf Glimmer oder Gold-Einkristalle verwendet. Dies liegt darin begründet, dass diese Bottomelektroden eine niedrige und gut reproduzierbare Oberflächenrauhigkeit bilden und der Gold-Schwefel-Kontakt bevorzugt ist. Dies hat jedoch den Nachteil, dass der vorherrschende CMOS-Prozeß bei dem Silizium als Substrat verwendet wird, nicht eingesetzt werden kann.

Es ist daher Aufgabe der Erfindung, ein verbessertes Verfahren zum strukturierten Aufbringen von Molekülen auf eine Leiterbahn bereitzustellen, mit dem die oben genannten Nachteile überwunden werden können.

Ausgehend vom Oberbegriff des Anspruchs 1 wird die Aufgabe erfindungsgemäß gelöst mit den im kennzeichnenden Teil des Anspruchs 1 angegebenen Merkmalen.

Mit dem erfindungsgemäßen Verfahren ist es erstmals möglich, kostengünstig eine beliebige Anzahl von Molekülen bzw. Molekülspeicherelementen in strukturierter Weise gezielt auf eine Leiterbahn aufzubringen und damit erstmals eine Speichermatrix auf Molekülebene bereitzustellen. Mit der durch das erfindungsgemäße Ver fahren hergestellten Speichermatrix ist es nunmehr möglich, dass eine sehr hohe Speicherdichte erreicht werden kann, die mit bisher bekannten Speichermedien nicht erzielt werden kann.

Vorteilhafte Weiterbildungen sind in den Unteransprüchen angegeben.

Die Zeichnungen zeigen schematisch eine von vielen möglichen Ausführungsformen des erfindungsgemäßen Verfahrens.

Es zeigt:
- Fig. 1:: Verfahrensschritte für das strukturierte Aufbringen von Molekülen auf eine Leiterbahn
- Fig. 2:: Aufbau von Mizellen und deren Zusammensetzung

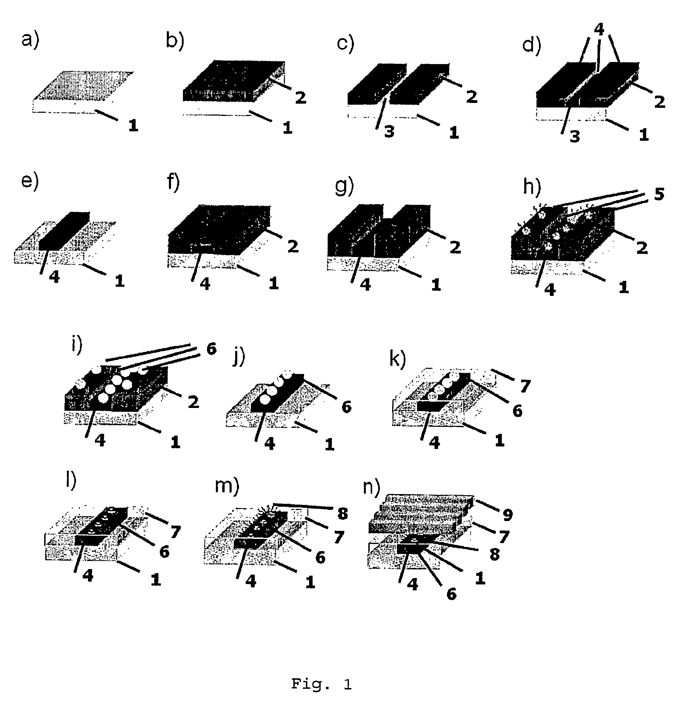

Figur 1 zeigt beispielhaft schematisch die möglichen Verfahrensschritte für das strukturierte Aufbringen von Molekülen auf eine Leiterbahn sowie zur Herstellung einer molekularen Speichermatrix. Schritt a) zeigt das Substrat 1. Schritt b) zeigt das mit Photolack 2 beschichtete Substrat 1. Schritt c) zeigt die im Photolack 2 erzeugte gewünschte Struktur 3 . Schritt d) zeigt die auf dem strukturierten Photolack aufgebrachte Schicht, die als Leiterbahn 4 dienen soll. Schritt e) zeigt die verbliebene Leiterbahn 4 auf dem Substrat 1 nach dem "Lift-Off". Schritt f) zeigt den aufgeschleuderten Photolack 2 über der Leiterbahn 4 und dem Substrat 1. Schritt g) zeigt die vom Photolack 2 mittels bekannter Strukturier-Verfahren freigelegte Leiterbahn 4. Schritt h) zeigt die auf der Leiterbahn 4 und dem Photolack 2 aufgebrachten Mizellen 5. Schritt i) zeigt die durch z.B. Plasmaätzen von den Polymerketten befreiten metallischen Cluster 6, die als Ankerplätze für Moleküle dienen können. Schritt j) zeigt die durch "lift-off" freigelegte Leiterbahn 4 mit den aufgelagerten metallischen Cluster 6. Schritt k) zeigt die mit einer Schutzschicht 7 bedeckte Leiterbahn 4 und das bedeckte Substrat 1. Schritt 1) zeigt die in der Schutzschicht 7 durch Ätzen freigelegten metallischen Cluster 6. Schritt m) zeigt die mit den freigelegten Ankerplätzen der metallischen Cluster 6 verbundenen funktionalen Moleküle 8. Schritt n) zeigt die durch z.B. Aufdrucken aufgebrachte Top-Elektrode 9 über den in der Schutzschicht 7 auf dem Substrat 1 eingebetteten metallischen Cluster 6 mit den gebundenen funktionalen Molekülen 8.

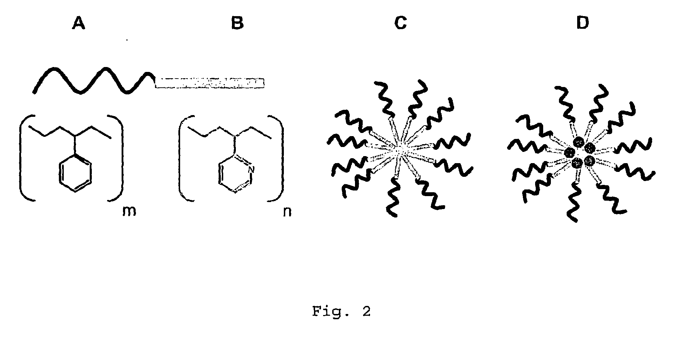

Figur 2 zeigt den Aufbau vom Mizellen und deren Zusammensetzung, bestehend aus einem hydrophoben (A) und einem hydrophilen (B) Molekülteil, wobei "m" die Anzahl der hydrophoben und "n" die Anzahl der hydrophilen Molekülteile angibt. In einem apolaren Lösungsmittel kommt es zur Mizellenbildung (C). (D) zeigt eine mit metallischen Clustern beladene Mizelle.

Im Folgenden sollen die einzelnen Verfahrensschritte beispielhaft näher beschrieben werden, wobei die Verfahrensschritte a)-e) mehrere nach dem Stand der Technik bekannte Verfahren zur Strukturierung von Leiterbahnen wiedergeben. Ab Schritt f) wird das erfindungsgemäße Verfahren zum strukturierten Aufbringen von Molekülen auf eine Leiterbahn verdeutlicht.

Das Substrat 1 (Schritt a), welches aus Silizium dem vorherrschendem Material des CMOS-Prozesses besteht, wird zunächst durch Aufschleudern mit Photolack 2 beschichtet (Schritt b). Anschließend wird ein Teil des Photolacks 2 belichtet (Schritt c), so dass eine gewünschte Struktur, wie z. B. eine schmale Spur 3 mit beispielsweise einer Breite von ca. 2 bis 20 nm für eine Leiterbahn 4, in der Schicht des Photolacks 2 nach dem anschließenden Entwickeln entsteht. Dies kann beispielsweise durch die Elektronenstrahllithographie erfolgen, wobei alle bekannten direkten und indirekten Verfahren, die es erlauben, eine strukturierte Leiterbahn aufzubringen, ebenfalls geeignet sind. Mit Hilfe der nach dem Stand der Technik bekannten Verfahren ist es möglich, jede beliebige gewünschte Struktur sowie Fläche in die Schicht des Photolacks 2 einzuarbeiten und somit auch beliebige Strukturen als Leiterbahn 4 zu verwenden.
Im nächsten Schritt wird auf die durch Lithographie freigelegte Struktur 3 sowie auf die noch verbliebene Fläche des Photolacks 2 das Material für die Leiterbahn 4 aufgebracht (Schritt d). Dabei können beispielsweise bekannte Verfahren wie das Aufdampfen oder Sputtern zum Einsatz kommen. Eine Grundbedingung, welche die Leiterbahn 4 erfüllen muss, ist eine gute elektrische Leitfähigkeit. Aus diesem Grund sollten Materialien wie z. B. Gold, Kupfer, Aluminium oder Platin verwendet werden. Im weiteren Verfahrensschritt (auch "lift-off" genannt) (Schritt e) wird die Schicht des Photolacks 2 mit dem aufgetragenen Material der Leiterbahn 4 durch Behandlung mit einem Lösungsmittel, z. B. Aceton, von dem Substrat 1 gelöst, so dass nur noch die direkt auf dem Substrat 1 aufliegende Leiterbahn 4 verbleibt.
Nun wird wieder eine Schicht Photolack 2 aufgeschleudert, die sich über das Substrat 1 und die Leiterbahn 4 legt (Schritt f). Im nächsten Verfahrensschritt (Schritt g) wird erneut z.B. durch einen Elektronenstrahl und eine anschließende Entwicklung die Schicht des Photolacks 2 über der Leiterbahn 4 entfernt und die Leiterbahn 4 freigelegt. Durch Eintauchen dieser Anordnung in eine Lösung mit Mizellen 5, die mit metallischen Ionen oder Clustern 6, wie beispielsweise mit Goldionen oder Goldclustern, beladen sind, lagern sich die Mizellen 5 auf dem Photolack 2 sowie direkt auf der Leiterbahn 4 an (Schritt h).
Mizellen 5 bestehen aus amphiphilen Moleküle, die sich aus einem hydrophoben und einem hydrophilen Molekülteil zusammensetzen, welche in einem apolaren Lösungsmittel wie z. B. Toluol) Mizellen 5 bilden (J. Spatz, M. Möller, P.Ziemann, Phys. Blätter 55, 49 (1999))*.*
Im Kern dieser Mizellen 5 können unterschiedlichste Metalle wie z. B. Gold, Platin, Palladium, Titan, Indium, Silber, Kupfer oder auch Gallium oder andere gewünschte metallische Cluster eingelagert werden. Unter dem Begriff "Cluster" sollen im Rahmen der vorliegenden Erfindung sowohl Cluster bestehend aus mehreren Metallatomen als auch eine Ansammlung von Metallionen, die durch Reduktion in Cluster überführt werden können, verstanden werden. Nach Entfernen der Polymere, z. B. durch Behandlung mit einem reaktiven Plasma, das so genannte Plasmaätzen, werden die Polymere verdampft oder chemisch abgetragen, je nach Stärke und Art des Plasmas (Schritt i). Durch diesen Verdampfungsprozess verbleiben nur die in den Mizellen eingelagerten metallischen Cluster 6 auf der Leiterbahn 4 bzw. der Schicht des Photolacks. Im nächsten Schritt (Schritt j) wird der Photolack 2 durch Behandlung mit Lösungsmittel (z.B. Aceton) abgelöst, so dass nur die Leiterbahn 4 mit den stabil gebundenen metallischen Clustern 6 wie z.B. den Goldclustern verbleibt. Im Folgenden (Schritt k) werden die einzelnen metallischen Cluster 6, die später als Ankerplätze für Moleküle dienen, untereinander durch Aufbringen einer Schutzschicht 7 ("protection-layer"), welche aus elektrisch isolierenden Materialien, wie beispielsweise Siliziumoxid, besteht, elektrisch isoliert sowie vor weiteren direkten Umwelteinflüssen geschützt. Durch Behandlung der Oberfläche mit einem abtragenden Verfahren wie z.B. der "RIBE" (reactive ion beam echting), werden die metallischen Cluster 6 wieder aus der Schutzschicht 7 freigelegt, so dass die Oberflächen der metallischen Cluster 6 zugänglich sind (Schritt 1). Auf diese metallischen Cluster 6 werden nun die funktionalen Moleküle 8 aufgebracht (Schritt m). Dies kann beispielsweise durch Eintauchen in eine mit Molekülen angereicherte Lösung aber auch durch Aufdampfen von Molekülen aus der Gasphase geschehen. Die Bindung der funktionalen Moleküle 8 an die Ankerplätze der metallischen Cluster 6 kann über z.B. Gold-Schwefel-Brückenbindungen erfolgen. Durch Aufbringen der Top-Elektrode 9 z.B. mittels Aufdrucken ("Imprint") ist das Verfahren abgeschlossen (Schritt n).

Die vorliegende Erfindung betrifft ein Verfahren zum strukturierten Aufbringen von Molekülen auf eine Leiterbahn, umfassend folgende Verfahrensschritte,
- Aufbringen von Mizellen 5 mit eingelagerten metallischen Clustern 6 auf eine strukturierte Leiterbahn 4,
- Entfernen der Polymerketten der Mizellen 5 um die metallischen Cluster 6,
- Aufbringen einer elektrisch isolierenden Schutzschicht 7 auf die metallischen Cluster 6,
- Freilegen der metallischen Cluster 6 aus der Schutzschicht 7, so dass die Oberflächen der metallischen Cluster 6 zugänglich sind,
- Bindung der funktionalen Moleküle 8 an die metallischen Cluster 6.
Der Abstand der metallischen Cluster 6 untereinander kann direkt durch die Variation der Länge der Polymerketten der die Mizellen 5 bildenden Moleküle definiert eingestellt werden. Die Zahl der funktionalen Moleküle 8 pro metallischen Cluster 6 kann durch die Größe des freigelegten metallischen Clusters 6 definiert eingestellt werden (d.h. sowohl durch die Größe des metallischen Clusters 6 als auch durch die Größe des freigelegten Querschnitts des metallischen Clusters 6). Da die Mizellen 5 in der Lage sind, sich selbst in geordneter Weise auf der strukturierten Leiterbahn anzuordnen, entfallen aufwendige und kostspielige Verfahrensschritte zum Strukturieren der Speichermatrix. Damit wird es möglich, kostengünstig und auf eine einfache Art und Weise eine ultimativ dichte Speichermatrix, deren Punktdichte allein durch die Moleküldimension der funktionalen Moleküle limitiert wird, aufzubauen.

In einer weiteren vorteilhaften Ausgestaltung des Verfahrens werden Leiterbahnen 4 mit unterschiedlicher Breite auf der Substratoberfläche realisiert. Weiterhin werden Mizellen 5 unterschiedlicher Größe und mit unterschiedlich beladenen metallischen Clustern 6 eingesetzt.
Die Größe der Mizellen 5 kann durch die hydrophoben und hydrophilen Anteile der Mizelle 5 eingestellt werden.

Hierdurch wird erreicht, dass sich die Mizellen 5 ihrer Größe entsprechend nur in die dafür vorgesehenen und vorher strukturierten Leiterbahnen 4 unterschiedlicher Breite oder entsprechende Fläche anordnen. Beispielsweise werden zuerst durch Aufbringen von "großen" Mizellen 5 breite Leiterbahnen 4 besetzt. Anschließend werden dann "kleine" Mizellen 5 mit anderen Metallclustern beladen und in schmale Leiterbahnen 4 eingelagert. So können die unterschiedlichsten metallischen Cluster 6 auf einer einzigen Substratoberfläche in strukturierter Art und Weise aufgebracht werden. In einer vorteilhaften Ausführung des Verfahrens wird als metallischer Cluster 6 mindestens eine Komponente aus der Gruppe Au, Pt, Pd, Ti, Fe, In, Ag, Co, und/oder Ga eingesetzt. Die unterschiedlich großen metallischen Cluster 6 ordnen sich entsprechend der Größe der Mizellen 5 auf den unterschiedlich großen Flächen oder Breiten der Leiterbahnen 4 an. Dies hat den Vorteil, dass auch unterschiedlich schaltfähige Moleküle mit entsprechend unterschiedlichen Ankergruppen selektiv an die definiert positionierten metallischen Cluster binden können (z.B. Moleküle mit COOH-Ankergruppen an Ti-Cluster und Moleküle mit SH-Ankergruppe an Gold-Cluster). Dies hat den Vorteil, dass selektiv verschiedene (mindestens zwei verschiedene) funktionale Moleküle 8 spezifisch an die vordefinierten verschiedenartigen Ankerplätze der metallischen Cluster 6 binden können und so eine Speichermatrix mit unterschiedlich definierbaren Eigenschaften konstruiert werden kann.

Eine vorteilhafte Ausführung des Verfahrens ist dadurch gekennzeichnet, dass Mizellen 5 mit unterschiedlich langen Polymerketten eingesetzt werden. So können beispielsweise Mizellen 5 mit Polymerketten zwischen 10 - 200 nm eingesetzt werden. Dies ermöglicht es, die Punktdichte für die funktionalen Moleküle 8, die beispielsweise zwischen ca. 10⁹ -10¹¹ Molekülspeicherelementdichte/mm² liegen kann, definiert einzustellen.

In einer weiteren vorteilhaften Ausführung des Verfahrens werden metallische Cluster 6 unterschiedlicher Größe eingesetzt. So kann die Anzahl der funktionalen Moleküle 8 pro Fläche definiert eingestellt werden. Die metallischen Cluster 6 können beispielsweise einen Durchmesser von 0,5-20 nm aufweisen. Da die funktionalen Moleküle 8 eine Fläche von 0,1 bis 1,5 nm² einnehmen können, ergibt sich, dass je nach Durchmesser der metallischen Cluster 6 zwischen ca. 1-3500 funktionale Moleküle 8 an die Ankerplätze der metallischen Cluster 6 binden können.

In einer vorteilhaften Ausführung des Verfahrens wird durch den Ätzprozess die Zugänglichkeit der Oberfläche der metallischen Cluster 6 und damit die Anzahl der Ankerplätze pro metallischem Cluster 6 variiert. Je mehr die Oberfläche der metallischen Cluster 6 aus der Schutzschicht freigelegt wird, desto mehr Ankerplätze stehen den funktionalen Molekülen 8 zur Verfügung. Somit ist eine weitere Möglichkeit gegeben, die Anzahl der funktionalen Moleküle 8 auf dem metallischen Cluster 6 definiert einzustellen.

Eine vorteilhafte Ausführung des Verfahrens umfasst die Verwendung funktionaler Moleküle 8, die bei Veränderungen des elektrischen Feldes, der elektromechanischen Bedingungen, Veränderungen des Lichts und/oder der elektrochemischen Bedingungen mit einer Änderung der Ladungsdichte, der Elektronenkonfiguration, einer Konformationsänderung oder Bewegung einer Atomgruppe, einem angeregten Zustand eines Elektrons und/oder einer Änderung des magnetischen Spins reagieren.

Der Vorteil des erfindungsgemäßen Verfahrens liegt darin, dass funktionale Moleküle, die als Speicherelemente (= Molekülspeicherelemente) eingesetzt werden können, in Bündeln von wenigen Molekülen (1-N, N<100 und bevorzugt N~2-10, wobei N gleich der Anzahl der Moleküle), deren Anzahl durch die Größe der Ankerplätze vorgegeben wird, in definierten Abständen von 10-200nm auf Leiterbahnen beliebigen Materials aufgebracht werden können. Nur auf diese Weise können die diskreten Energieniveaus der Einzelmoleküle für Speicher bzw. Schaltelemente ausgenutzt werden.

Wenn es für die Durchführung des Verfahrens zweckmäßig ist, können weitere Verfahrensschritte eingefügt werden ohne das Verfahren zu beeinträchtigen.

Gegenstand der vorliegenden Erfindung ist weiterhin eine molekulare Speichermatrix hergestellt durch das erfindungsgemäße Verfahren.

## Patentansprüche

1. Verfahren zum strukturierten Aufbringen von Molekülen auf eine Leiterbahn,
umfassend folgende Verfahrensschritte, die in der genannten Reihenfolge ausgeführt werden:
- Aufbringen von Mizellen (5) mit eingelagerten metallischen Clustern (6) auf eine strukturierte Leiterbahn (4),
- Entfernen der Polymerketten der Mizellen (5) um die metallischen Cluster (6),
- Aufbringen einer elektrisch isolierenden Schutzschicht (7) auf die metallischen Cluster (6),
- Freilegen der metallischen Cluster (6) aus der Schutzschicht (7), so dass die Oberflächen der metallischen Cluster (6) zugänglich sind,
- Bindung der funktionalen Moleküle (8) an die metallischen Cluster (6).

2. Verfahren nach Anspruch 1,
**dadurch gekennzeichnet,**
**dass** als metallische Cluster (6) mindestens eine Komponente aus der Gruppe Au, Pt, Pd, Ti, Fe, In, Ag, Co, und/oder Ga eingesetzt wird.

3. Verfahren nach einem der Ansprüche 1 bis 2,
**dadurch gekennzeichnet,**
**dass** das Aufbringen der Mizellen (5) durch Eintauchen des Substrats (1) in eine Lösung mit Mizellen (5) durchgeführt wird.

4. Verfahren nach einem der Ansprüche 1 bis 3,
**dadurch gekennzeichnet,**
**dass** Mizellen (5) mit unterschiedlich langen Polymerketten eingesetzt werden.

5. Verfahren nach einem der Ansprüche 1 bis 4,
**dadurch gekennzeichnet,**
**dass** Mizellen (5) mit Polymerketten zwischen 10 - 200 nm eingesetzt werden.

6. Verfahren nach einem der Ansprüche 1 bis 5,
**dadurch gekennzeichnet,**
**dass** metallische Cluster (6) unterschiedlicher Größe eingesetzt werden.

7. Verfahren nach einem der Ansprüche 1 bis 6,
**dadurch gekennzeichnet,**
**dass** metallische Cluster (6) mit einer Größe von 0,5 -20 nm eingesetzt werden.

8. Verfahren nach einem der Ansprüche 1 bis 7,
**dadurch gekennzeichnet,**
**dass** durch einen Ätzprozess die Größe der Ankerplätze der metallischen Cluster (6) variiert wird.

9. Verfahren nach einem der Ansprüche 1 bis 8,
**dadurch gekennzeichnet,**
**dass** funktionale Moleküle (8) verwendet werden, die bei Veränderungen des elektrischen Felds, der elektromechanischen Bedingungen, Veränderungen des Lichts und/oder der elektrochemischen Bedingungen mit einer Änderung der Ladungsdichte, der Elektronenkonfiguration, einer Konformationsänderung oder Bewegung einer Atomgruppe, einem angeregten Zustand eines Elektrons und/oder einer Änderung des magnetischen Spins reagieren.

## Claims

1. Method for structured application of molecules on a strip conductor,
comprising the following steps, which are carried out in the sequence indicated:
- application of micelles (5) with incorporated metallic clusters (6) on a structured strip conductor (4),
- removal of the polymer chains of the micelles (5) around the metallic clusters (6),
- application of an electrically insulating protective layer (7) to the metallic clusters (6),
- exposure of the metallic clusters (6) from the protective layer (7) so that the surfaces of the metallic clusters (6) are accessible,
- connection of the functional molecules (8) to the metallic clusters (6).

2. Method according to claim 1,
**characterised in that**
at least one component from the group Au, Pt, Pd, Ti, Fe, In, Ag, Co, and/or Ga is used as the metallic clusters (6).

3. Method according to claims 1 to 2,
**characterised in that**
the application of micelles (5) is carried out by immersing the substrate (1) in a solution with micelles (5).

4. Method according to one of claims 1 to 3,
**characterised in that**
micelles (5) with varying lengths of polymer chains are used.

5. Method according to one of claims 1 to 4,
**characterised in that**
micelles (5) with polymer chains between 10 - 200 nm are used.

6. Method according to one of claims 1 to 5,
**characterised in that**
metallic clusters (6) varying in size are used.

7. Method according to one of claims 1 to 6,
**characterised in that**
metallic clusters (6) 0.5 - 20 nm in size are used.

8. Method according to one of claims 1 to 7,
**characterised in that**
the size of the anchorages of the metallic clusters (6) is varied by an etching process.

9. Method according to one of claims 1 to 8,
**characterised in that**
functional molecules (8) are used, which react, when there are changes to the electrical field, electromechanical conditions, changes to the light and/or electrochemical conditions with a change in the charge density, electron configuration, change to the conformation or movement of an atom group, an excited state of the electron and/or a change to the magnetic spin.

## Revendications

1. Procédé d'application structurée de molécules sur une piste conductrice,
comportant les étapes de procédé suivantes qui sont exécutées dans l'ordre indiqué :
- application de micelles (5) dans lesquelles sont intégrées des grappes métalliques (6) sur une piste conductrice structurée (4),
- élimination des chaînes de polymères des micelles (5) autour des grappes métalliques (6),
- application d'une couche protectrice électriquement isolante (7) sur les grappes métalliques (6),
- dégagement des grappes métalliques (6) de la couche protectrice (7), de telle manière que les surfaces des grappes métalliques (6) soient accessibles,
- liaison des molécules fonctionnelles (8) aux grappes métalliques (6).

2. Procédé selon la revendication 1,
**caractérisé en ce**
**qu'**on utilise comme grappes métalliques (6) au moins un composant choisi parmi le groupe se composant de l'Au, du Pt, du Pd, du Ti, du Fe, de l'In, de l'Ag, du Co et/ou du Ga.

3. Procédé selon l'une quelconque des revendications 1 à 2,
**caractérisé en ce que**
l'application des micelles (5) est réalisée en plongeant le substrat (1) dans une solution contenant des micelles (5).

4. Procédé selon l'une quelconque des revendications 1 à 3,
**caractérisé en ce que**
des micelles (5) à chaînes de polymères de longueurs différentes sont utilisées.

5. Procédé selon l'une quelconque des revendications 1 à 4,
**caractérisé en ce que**
des micelles (5) à chaînes de polymères allant de 10 à 200 nm sont utilisées.

6. Procédé selon l'une quelconque des revendications 1 à 5,
**caractérisé en ce que**
des grappes métalliques (6) de tailles différentes sont utilisées.

7. Procédé selon l'une quelconque des revendications 1 à 6,
**caractérisé en ce que**
des grappes métalliques (6) d'une taille de 0,5 à 20 nm sont utilisées.

8. Procédé selon l'une quelconque des revendications 1 à 7,
**caractérisé en ce que**
on fait varier la taille des points d'ancrage des grappes métalliques (6) par un procédé d'attaque.

9. Procédé selon l'une quelconque des revendications 1 à 8,
**caractérisé en ce que**
l'on utilise des molécules fonctionnelles (8), qui, en cas de modifications du champ électrique, des conditions électromécaniques, de modifications de la lumière et/ou des conditions électrochimiques, réagissent par une modification de la densité de charge, de la configuration des électrons, d'un changement de conformation ou d'un mouvement d'un groupe d'atomes, d'un état excité d'un électron et/ou d'une modification du moment magnétique.
